# EUROPEAN PATENT APPLICATION

(11) **EP 2 148 370 A1**
(43) Date of publication of application: **27.01.2010**
(21) Application number: 08160841.6
(22) Date of filing: 21.07.2008
(51) Int. Cl.: H01L 27/32

(54) **Structure of electro-optical devices**

(71) Applicant: Technische Universität Braunschweig, 38106 Braunschweig (DE)
(72) Inventor: Mozer, Steffen, 38100, Braunschweig (DE); Kowalsky, Wolfgang, 38116, Braunschweig (DE); Blei, Hendrik, 38114, Braunschweig (DE); Johannes, Hans-Hermann, 38124, Braunschweig (DE)
(74) Representative: Taruttis, Stefan Georg

(57) **Abstract**

The invention provides radiation emitting devices and solar cells, which comprise a radiation collecting compound wherein the radiation emitting or radiation collecting layer (20) is arranged between a first electrode (2) which is supported by a first side (11) of a substrate, while a second, at least partially radiation transparent second electrode (6) contacts the opposite surface of the radiation emitting or collecting layer (20) opposite the first electrode (2), wherein at least one electrically conductive connector (1) is arranged at the substrate, which connector (1) is insulated or separated from the first electrode (2) by a spacing (3), and wherein the second electrode (6) is in electric contact with the connector (1). For power supply, the first electrode is contacted by a first lead having a first polarity, and the connector (1), one or a plurality of which is preferably contacted by a conductor (5), preferably the conductor is contacted by a second lead of a second polarity opposite the first polarity.

## Description

The present invention relates to the structure of electro-optical devices, especially to organic light emitting diode (OLED) elements and solar cells, a process for their production, providing for an improved electric contact to two opposite sides of the organic layer for power conduction to or from two electrode layers arranged on opposite surfaces of an organic layer containing a light emitting or a light collecting organic compound.

### State of the art

DE 10 2005 032 741 A1 describes an OLED, wherein the organic light emitting layers are arranged between two parallel electrodes to form a pixel. Each pixel is arranged on top of a stack of parallel layers forming a transistor, contacting one of the electrodes adjacent the organic light emitting compound, thus providing for a transistor connected to each OLED pixel.

DE 10 2006 023 511 A1 describes an OLED comprising a stack of different luminescent regions arranged between two electrodes, with an intermediate electrode disposed between successive luminescent regions. The luminescent regions comprise an organic light emitter compound in a mixture with electron and hole transporting compounds. In prior art OLED devices, the organic light emitting layer is arranged between two surface electrodes which are electrically contacted by a lead each.

### Objects of the invention

In known OLED devices, homogeneity of electrical power supply to the light emitting layer by the two contacting electrodes is insufficient for larger surfaces. Accordingly, it is an object of the present invention to provide an organic light emitting device (OLED) and a method for its production having a structure for increased homogeneity of the light emittance over the surface of the OLED.

### General description of the invention

The invention achieves these objects by providing an OLED device and a method for its production as well as to a device for performing the preferred method of production as defined in the claims.

In the following, the invention is described with reference to a radiation emitting device. The features of the radiation emitting devices also pertain to radiation collecting devices, also termed solar cells, which comprise a radiation collecting compound that converts radiation energy into charge separation instead of an emitter compound that converts charge into radiation. As the electric contacts and structure of both devices of the invention are identical, except for contacting an organic layer comprising a light collecting compound or a radiation emitting compound, respectively, the description with reference to one device relates to both types of devices.

A radiation emitting device comprises a radiation emitting layer having a first surface and an opposite second surface, which radiation emitting layer (20) comprises a radiation emitting compound, the radiation emitting layer is arranged between a first electrode, the first side thereof contacting the first side of the radiation emitting layer, which first electrode (2) is supported e.g. by a first side of a substrate, the radiation emitting device a second, at least partially radiation transparent second electrode contacting the second surface of the radiation emitting layer opposite the first side contacted by the first electrode, wherein at least one electrically conductive connector is arranged at the substrate, which connector is insulated or separated from the first electrode by a spacing, and wherein the second electrode is in electric contact with the connector. For insulation of the connector from the first electrode, it is preferred that an insulating material, e.g. at least a fraction of the radiation emitting layer or organic compounds with a conductivity significantly lower than that of the radiation emitting layer, extends into the spacing. For power supply, the first electrode is contacted by a first lead having a first polarity, and the connector, one or a plurality of which is preferably contacted by a conductor, preferably the conductor is contacted by a second lead of a second polarity opposite the first polarity.

Generally, a radiation emitting layer, preferably comprising an organic light emitting compound, is contacted by a first electrode, which can be light transparent or non transparent, and an opposite second surface electrode, which is transparent to least a fraction of the light produced by the organic layer. In contrast to state of art devices, the second electrode is not or not only directly contacted by a lead, but without or in addition to contact with a peripheral lead contacting the second electrode for power supply, the second electrode is contacted by at least one, preferably by a multitude of electrically conductive connectors which are arranged within or at the substrate supporting the first electrode and the adjacent composition of current transporting and radiation emitting compounds forming the radiation emitting layer, which preferably is an organic layer. For electric separation from the first electrode, the connector is spaced from the first electrode. The second electrode contacts the second surface of the of the radiation emitting layer opposite the first surface, which is contacted by the first electrode. The radiation emitting layer has a second surface that is contacted by the second electrode. The second electrode is electrically contacted by the at least one connector, preferably also contacted by leads arranged at its circumferential edges. For spacing of the first electrode from the connector and the second electrode, which is in electric contact with the connector, the radiation emitting layer or a fraction thereof can be arranged to extend to the space between the first electrode and the connector, forming an insulating section between the first electrode and the connector. Generally, this insulating section is regarded as sufficiently insulating when is has a conductivity significantly lower than the conductivity of the complete radiation emitting layer. The space between the first electrode and the connector can be provided or filled by an insulating material, e.g. by the substrate supporting the first electrode. As a result, at least a fraction of the compounds of the radiation emitting layer is disposed between the second electrode covering the second side of the radiation emitting layer and the first electrode on the first side of the radiation emitting layer.

For enhanced separation of the connector and/or the second electrode from the first electrode, the fraction of the radiation emitting layer extending to the space separating the connector from the first electrode has high resistivity, and in relation to the arrangement of the radiation emitting layer is preferably arranged in reverse direction and/or incompletely to minimize conductivity.

Further, separation of the connector from the first electrode can be enhanced by insulating material arranged circumferentially to the connector, resulting in the insulating material disposed between the first electrode and the connector. In this embodiment, the complete or partial radiation emitting layer extending into the space between the connector and the first electrode can fully or partially extend to the insulating material. A major effect for enhanced separation of the connector from the first electrode provided by the insulating material arranged circumferentially to the connector is the increased distance for currents between the connector and the first electrode. For example, the use of a photoresist lacquer as the insulating material creates a barrier circumferential to the connectors which barrier is in the µm to mm range and is at least two orders of magnitude higher on the substrate than the thickness of the radiation emitting layer, which e.g. for organic light emitting diodes (OLEDs) is in the nm range.

For creating a space between the connector and the first electrode, first electrode material is preferably removed circumferentially to the connector prior to deposition of the second electrode material. For removal of first electrode material circumferentially to the connector for spacing first electrode material from the connector, the area defining the space between the connector and the first electrode, e.g. a space circumferential to the connector, can be removed by heating, e.g. desorbed or ablated using laser irradiation, by a mechanical lift off-process, or a photolithographic processes using deposition of a removable coating circumferential to the connector with subsequent removal of the coating including the first electrode material in the area defining the space between connector and first electrode. Preferably, following removal of first electrode material circumferential to a connector, the compounds constituting the radiation emitting layer are deposited. For contact of the second electrode material to be deposited onto the second side of the radiation emitting layer and contacting the connector, the deposition of radiation emitting layer compounds is directed to leave at least a fraction of the surface of the connector uncovered by radiation emitting layer compounds, e.g. by masking the connector or following deposition of the radiation emitting layer compounds by removal of radiation emitting layer compounds from the connector by lithographic processes or desorption or ablation, e.g. using laser irradiation. In case, first electrode material and radiation emitting layer compounds are first deposited to also cover the connector, both the first electrode material and radiation emitting layer compounds can be removed in a common desorption process, e.g. using lithography or heating, preferably by laser irradiation, more preferably to an area including the connector and a circumferential space around the connector.

Accordingly, it is preferred to provide for an insulating spacing between the connector and the first electrode material as well as for removal of radiation emitting layer compounds from the connector surface heating of the area defining spacing and of the surface of the connector by laser irradiation.

When using masking of the area circumferential to a connector and/or of the connector itself to prevent deposition of first electrode material to an area circumferential to the connector and of radiation emitting layer compounds at least from the connector, a mask can be used during deposition of the respective compounds, which mask has supporting sections carrying masking sections. The masking sections have an area extent sufficient to approximately cover an area circumferential to the connector, optionally including the surface of the connector, for generating the insulating spacing between connector and first electrode, and in an optional second mask, a covering section extending essentially across a surface of the connector. The supporting sections serve to carry the masking sections, and preferably the supporting sections have a very small diameter for reduction of undesired shadowing. However, an interruption of the first electrode layer and/or of the radiation emitting layer at lines extending between connectors, which lines are caused by shadowing of the supporting sections of a mask, do not destroy the conduction of current across the radiation emitting device, because the connectors are arranged to provide contact to the second electrode material, and the first electrode can be contacted by leads from the periphery of the radiation emitting device and/or from the second surface of the substrate.

As a consequence of the at least one connector contacting of the second electrode, the electric contact, e.g. power supply, to the transparent superficial second electrode layer adjacent the second surface side of the radiation emitting layer is only provided by or supplemented by one or a multitude of connectors. For example, the connectors contacting one essentially continuous second electrode can be arranged within a single or adjacent picture elements (pixel) which are contacted by one common second electrode.

Electric connection to the connector or to the multitude of connectors, e.g. for power supply, is provided through the contact of the second electrode with the electric conductor, which is preferably in the form of a metal conductor, e.g. a conductor layer. The conductor is isolated from the first electrode and is preferably arranged on the second side of the substrate opposite the first side of the substrate adjacent the first electrode layer. In an alternative embodiment of the arrangement of the conductor, the conductor can be arranged between the first side of the substrate and the first electrode with an insulating layer or a spacing arranged between the first electrode and the conductor. As a consequence of the arrangement of an electric conductor, which is in electric contact with the electrically conductive connectors which are spaced and/or isolated from the first electrode, both the first electrode and the conductor are arranged on one surface side of the radiation emitting layer and, accordingly, both the first electrode layer and the electric conductor can be optically non transparent as radiation can exit the radiation emitting layer through the transparent second electrode.

In accordance with the number and spacing of connectors which are essentially in electric contact only with the conductor and the transparent second electrode layer, the homogeneity of current supply to the second electrode layer is increased. Especially preferred, the electric conductor has a low resistance, e.g. an electric conductor of metal, preferably being formed as a layer, e.g. a preferably radiation transparent layer of metal and/or of metal oxide.

The connector can be a conductive material, e.g. metal, arranged in an opening, e.g. a boring traversing the insulating layer separating the conductor from the first electrode. In these embodiments, the insulating layer can be the substrate itself. The conductive material then is contacted by the conductor on the second side of the substrate opposite the radiation emitting layer. Within the opening, the connector can extend to the first surface of the substrate or it can extend through the optional insulating material arranged circumferentially to the connector, or the connector can be recessed in the opening and/or in the optional insulating material arranged circumferentially to the connector for contacting by the second electrode within the opening and/or in the optional insulating material. In the latter embodiment, the second electrode extends into the opening or between the insulating material to provide for electric contact between the connector and the second electrode.

In embodiments comprising connectors extending within openings of the substrate from the second side of the substrate, it is preferred to first produce the connector arranged within openings of the substrate, optionally with contacting the connector by a conductor arranged at the second side of the substrate opposite the radiation emitting layer. The first electrode is then applied to the first side of the substrate with a space separating the first electrode from the surface of the connector accessible from the first side of the substrate. For application of the first electrode, local deposition, e.g. using masking of the connector can be used and/or application of the first electrode including covering the connector with subsequent local removal of the first electrode from the connector and from the substrate in an area circumferential to the connector to generate a non-conducting space between the first electrode and the connector. Generally optionally, an insulating material, e.g. a photoresist lacquer, is applied circumferentially to the connector, which may extend to a section of the first electrode spaced from the connector but neighbouring the connector. As in the case of local application of radiation emitting layer or first electrode material, the insulating material can be applied locally using standard processes, including e.g. masking, leaving a ring-shaped area circumferential to the connector for deposition of the insulating material, in a preferred embodiment, an insulating spacing between the first electrode and the surface of the connector is generated by application of the insulating material, e.g. by lithography or coating from solution or vapour across an area including the connector with subsequent removal of the insulating material, e.g. by local removal using dissolution or evaporation using laser irradiation.

As at least one of the surface electrodes contacting the organic light emitting layer has be transparent in order to permit the light generated within the organic layer to exit the OLED, at least the second electrode is optically transparent. Suitable transparent electrodes can be produced from transparent conductive metal oxides, for example from indium tin oxide (ITO), aluminium-doted zinc oxide (AZO), thin metal layers or composite layers of these, which can be deposited by chemical or physical vapour deposition, sputtering and other methods known in the art.

Preferably, the conductor is arranged on one side of a stable supporting substrate used as a carrier for the radiation emitting layer, e.g. a glass or organic polymer sheet. The supporting substrate can on one side carry the conductor and the first electrode with an insulating layer arranged between the conductor and the first electrode, so that the first electrode has a first surface accessible by the radiation emitting layer and its second side on the insulating layer. In this embodiment, the substrate can be provided as a printed circuit board.

In one embodiment, the at least one connector is formed as a section of the conductor which is arranged between the first electrode contacting the radiation emitting layer and the first side of the substrate, wherein the conductor is insulated from the first electrode. Insulation of the conductor from the first electrode can be provided by a separating non-conducting layer arranged between the first electrode and the conductor, which can be a layer or in the form of conducting lines or a conducting grid. The connector is a section of the conductor where it is not covered by the insulation and not covered by the first electrode, e.g. where the insulation and first electrode layers are recessed or removed. In this embodiment, the conductor is arranged on the first side of the substrate, e.g. resulting in the substrate covering one side of the conductor and of the adjacent components of the electro-optical device of the invention.

For producing an electro-optical device of this embodiment, the substrate can be covered with conductor lines, a conductor grid or layer, followed by application of a non-conducting, e.g. an insulating layer. Onto the insulating layer, the first electrode can be positioned, e.g. as an electrode layer. Connectors can be generated by partial removal of the first electrode and the insulating material, e.g. by chemical, mechanical or physical removal to provide an accessible surface region of the connector, preferably by local evaporation of first electrode and insulating material by heating using laser irradiation. Removal of the first electrode and the insulating material can be in an essentially identical surface area, e.g. of the substrate, or the first electrode layer can be removed in an area exceeding the area of removed insulating material. The insulating layer between the first electrode and the conductor provides for the separation of the first electrode from the connector. The radiation emitting layer is preferably applied subsequent to removal of first electrode layer and insulating material to an area extending to the insulation between the connector and the first electrode, but excluding the area of removal of insulation from the conductor, e.g. excluding the accessible surface of the connector. For application of the radiation emitting layer, suitable known deposition processes can be used, e.g. vapour deposition of the compounds constituting the radiation emitting layer. For application of the radiation emitting layer with exclusion of at least a portion of the accessible connector surface, at least a portion of the connector surface can be masked during the application process, and/or the radiation emitting layer can be applied to cover the first electrode including complete covering of the connectors with subsequent removal of the radiation emitting layer from at least a fraction of the accessible surface of the connector. Removal of the radiation emitting layer can use mechanical processes, preferably laser irradiation for local evaporation of the radiation emitting layer from a portion of the connector.

In the embodiments of the invention, the second electrode having contact to the connector is applied to the radiation emitting layer by deposition of the second electrode material to an area essentially within the outer circumference of the radiation emitting layer, e.g. comprising the radiation emitting layer as well as the at least one connector or plurality of connectors distributed over the area within the outer circumference of the radiation emitting layer. Deposition of the second electrode material, e.g. by sputtering or vapour deposition, results in the contact of the second electrode with the connector and with the second surface of the radiation emitting layer including the area of spacing between the connector and the first electrode, the spacing including the optional insulating material arranged circumferentially to the connector. Due to at least a fraction of the radiation emitting layer material extending into the spacing between the first electrode and the connector, no direct contact of the second electrode to the first electrode is generated at deposition of the second electrode material.

For electro-optical devices having the radiation emitting layer realized by organic compounds in a structure according to the present invention, the radiation emitting layer covered by one second electrode has an increased homogeneity over the entire radiating surface, e.g. the luminescence except for the area of first electrode missing opposite the second electrode is more homogenous and is diminishing in a significantly reduced extent from the edge leads contacting the second electrode towards its centre in relation to OLED devices with contacting of the second electrode layer only by leads to the edges of the second electrode.

A preferred device for producing the electro-optical devices of the invention by the preferred process comprises an ultra-high vacuum chamber for receiving the substrate provided with at least one connector and the first electrode layer, optionally in addition provided with an organic layer comprising the radiation emitting or the radiation collecting compound, respectively. For removal of the first electrode layer circumferential to the connector, optionally including removal of the organic layer, a laser is arranged to irradiate the substrate in a region circumferential to the connector, optionally including the surface of the connector which is arranged e.g. in parallel to the first surface of the substrate, for heating to effect removal of first electrode layer, optionally also organic layer. Removal of the first electrode layer generates the insulating spacing that separates the first electrode from the connector. Preferably, the laser is controlled by a control unit for guiding the laser beam in a predetermined manner over the first surface of the substrate. For example, a control unit is a computer-controllable mirror arranged in the irradiation path of the laser. The laser can be arranged outside of the vacuum chamber when laser irradiation can pass a wall of the vacuum chamber, e.g. in a section transparent to the laser irradiation.

### Detailed description of the invention

The radiation, e.g. visible light emitting device according to the invention is described in greater detail with reference to the figures by way of example of an OLED, which schematically show in
- Figure 1 a partial elevation of a radiation emitting device,
- Figure 2 a cross-sectional view of one embodiment of a radiation emitting device,
- Figure 3 processing steps for producing a radiation emitting device,
- Figure 4 a cross-sectional view of another embodiment of a radiation emitting device, and
- Figure 5 a preferred device for production of the organic electro-optical devices of the invention.

In the figures, identical reference numerals refer to functionally identical elements. Leads connected to the first and second electrodes for providing current are not shown.

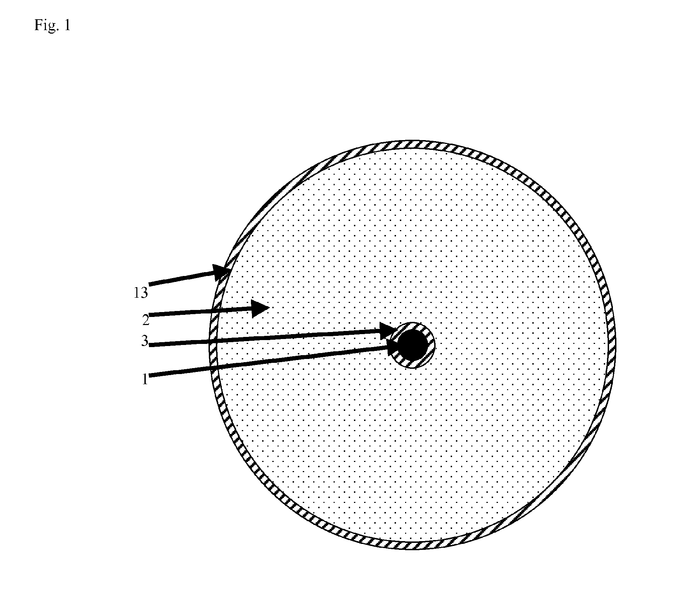

In Figure 1, a connector 1 is shown in the centre of a radiation emitting device, e.g. for use as a pixel, which connector 1 is arranged approximately centrally within the first electrode 2 arranged to surround connector 1. The first electrode 2 is separated from connector 1 by a spacing 3, e.g. of no or low conductivity providing for an effective insulation. The light emitting layer 20, for example a suitable admixture or layered structure of at least one emitter compound or a radiation collecting compound, which is an inorganic but preferably organic compound, respectively (not shown), covers first electrode 2 and exceeds first electrode 2 to extend into spacing 3 between connector 1 and first electrode 2. Preferably, the organic light emitting layer comprises or consists of a triplett emitter with charge transporting moieties and/or in admixture or adjacent layers with charge transporting compounds, e.g. hole transporting and electron transporting compounds. For separating one pixel from another one, first electrode 2 can be separated by an insulation surrounding first electrode 2 at its outer circumference. For OLEDs, preferred triplett emitter compounds preferably comprise a complexed iridium, e.g. as described in WO2007/028822 or in WO2006/072470. For solar cells, suitable light collecting organic compounds can e.g. be poly(3-hexylthiophene) in admixture with [6,6]phenyl-C61-butyric acid methyl ester (PCBM).

For charge transport from connector 1 to the surface of the light emitting layer, second electrode material (not shown) is deposited to cover the radiation emitting layer within its outer circumference, i.e. including the spacing 3, which spacing 3 is at least partially covered by at least a fraction of the compounds constituting the radiation emitting layer exceeding the first electrode 2. The arrangement of at least a fraction of the compounds constituting the radiation emitting layer to exceed the first electrode 2 for at least partially extending into and covering the spacing 3 that separates the first electrode 2 from the connector 1 generates an insulating layer between the first electrode 2 and the second electrode (not shown) which is arranged on the second surface of the radiation emitting layer and extends across the spacing 3 to the connector 1 for electric contact from connector 1 to the radiation emitting layer.

For enhanced insulation of the first electrode 2 from the second electrode by at least a fraction of the radiation emitting layer extending into spacing 3, the fraction of the radiation emitting layer can be selected from a constituent compound without charge transporting properties or with charge transport properties only in a direction reverse to the flow of current from the first electrode to the second electrode. Examples for such constituent compounds are without charge transport properties, e.g. silicon oxides, e.g. comprising SiO, MgF or a combination of electron and hole transporting layers in reverse biasing, e.g. selected from (*N*,*N*,*N*',*N*'-Tetrakis(4-methoxyphenyl)-benzidine, spiro-TAD (2,2',7,7'-T-etrakis-(*N*,*N*-diphenylamino)-9,9'-spirobifluoren), the hole conductor MeO-TPD, and/or the electron conductor TPBI (1,3,5-Tris(*N*-phenyl-2-benzylimidazol)-benzene), and/or a triplett emitter without charge transport moieties, or a hole transporting compound when the first electrode 2 is the cathode/anode and an electron transporting compound when the first electrode 2 is the anode/cathode. For the purposes of the invention, the section of the radiation emitting layer extending into the spacing 3 in the alternative or in addition to the compounds of the radiation emitting layer can be an insulating material deposited to cover the edge of the first electrode 2 in a region not covered by the radiation emitting layer adjacent spacing 3 and optionally extending into the spacing 3.

In the embodiments of the invention, the spacing 3 can be provided by the first surface of the substrate 10, and/or an insulating layer 13, a single layered or multi-layered arrangement of organic compounds having a significantly lower conductivity than the radiation emitting layer, an area of high resistivity, or a recess of the first electrode 2.

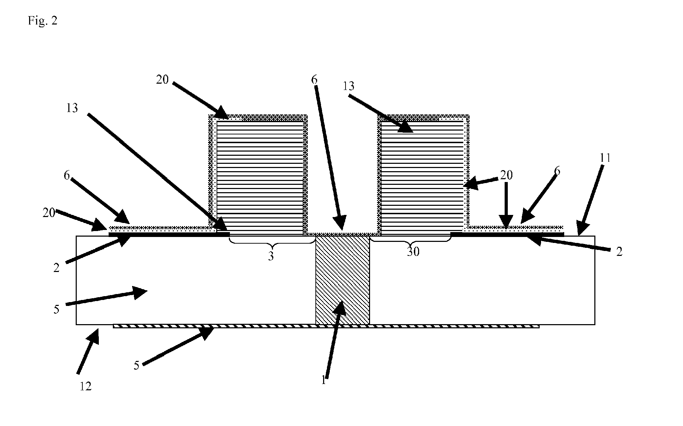

The cross-sectional view of Figure 2 shows connector 1 extending through substrate 10 from the second side 12 of the substrate 10 to the first side 11 of the substrate 10. On the second side 12 of the substrate 10, the connector is contacted by conductor 5, to which a current supply lead may be attached. First electrode 2 is positioned on the first side 11 of substrate 10 and is separated from connector 1 by spacing 3. For enhancement of the electric separation of connector 1 from first electrode 2, insulating material 13 is arranged circumferentially around connector 1, directly adjacent the first side 11 of substrate 10, covering at least a section of spacing 3 between connector 1 and first electrode 2, e.g. covering at least the area that is not covered by an insulating material 13 or by connector 1. The radiation emitting layer 20 covers at least a portion of the first electrode 2 and exceeds first electrode 2 to extend into the spacing 3, the surface of which is here enlarged by insulating material 13. In this schematic view, the proportions of insulating material 13 to the thickness of the first electrode 2, the radiation emitting layer 20 and second electrode 6 are not yet drawn to scale, as the thickness of the substrate 10 and of the insulating material 13 by far exceeds the thickness of the electrically and optically active layers including first and second electrodes 2, 6 and the radiation emitting layer 20.

Second electrode 6 provides for charge transport to light emitting layer 20 by contacting connector 1, covering the spacing 3 which includes the optional insulating material 13 to cover radiation emitting layer 20 opposite the first electrode 2.

Radiation is essentially limited to the area of the device where a radiation emitting layer 20 is covered by both the first electrode 2 and the second electrode 6, as charge transport between electrodes 2, 6 essentially only occurs in short pathways across the radiation emitting layer 20. Accordingly, sections of the device where no radiation emitting layer 20 is present, or where radiation emitting layer 20 is only contacted by one of first electrode 2 or second electrode 6, essentially no radiation is generated, which in the present example essentially is the area of spacing 3 and connector 1.

The first surface 2a of first electrode 2 contacts the first surface 20a of radiation emitting layer 20, whereas second surface 2b of the first electrode 2 lies against first side 11 of substrate 10. Second side 20b of radiation emitting layer 20 is contacted by second electrode 6.

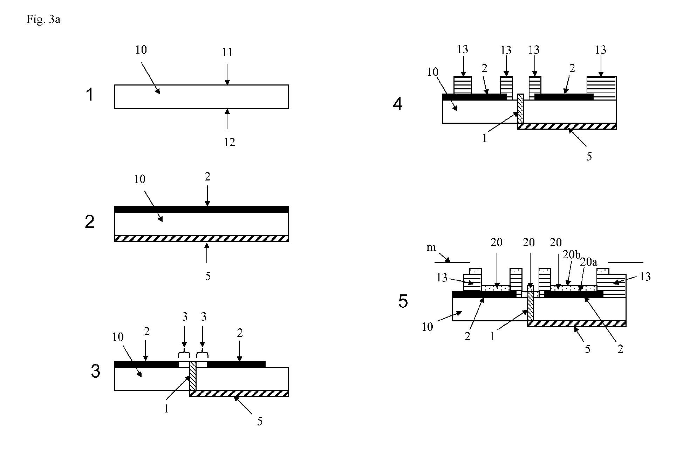

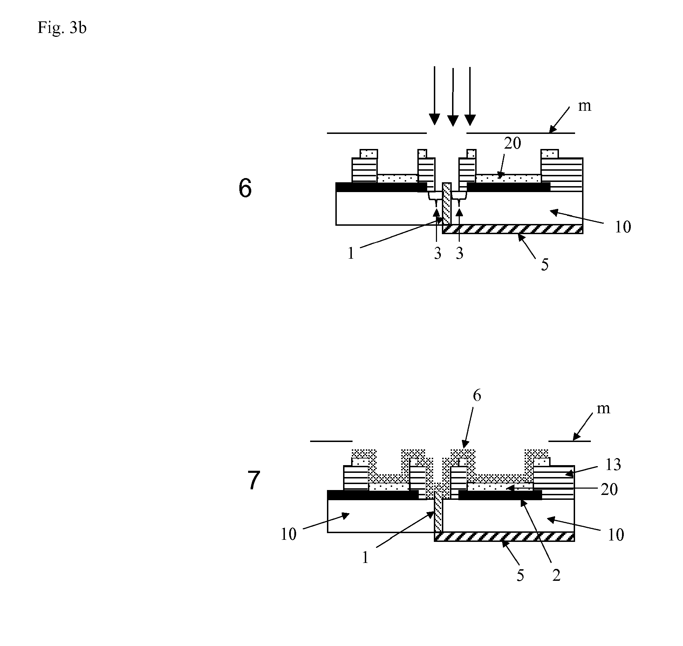

Figure 3 schematically shows an exemplary process for production of the radiation emitting device starting at step 1 with providing substrate 10, which at step 2 according to one embodiment is covered on the first side 11 with first electrode 2 and on second side 12 with the conductor 5. Generally, substrate 10 can be a surface of a multi-layered material, e.g. the insulating top layer covering a conductive material, or an electric or electro-optic component, e.g. a semi-conductor arrangement or a stacked further radiation emitting device according to the invention, e.g. an OLED.

Step 3 shows the result of providing an opening extending across the thickness of substrate 10 and arranging conductor 1 therein. Removing first electrode 2 from the first side 11 of the substrate 10 at least in a region circumferential to the opening containing connector 1 results in spacing 3 which separates first electrode 2 from connector 1.

At step 4, the optional disposition of insulating material 13 over a fraction of the spacing 3 is shown, wherein the insulating material 13 also extends to cover an edge region of the first electrode 2 adjacent spacing 3. Further, insulating material 13 can be disposed to cover a fraction of the first electrode 2, as shown in the left hand side of step 4, to generate a non irradiating section of the device.

As shown in step 3, a portion of the conductor 12 can be removed during the production process for structuring the conductor, e.g. in the configuration of a line, a grid or a continuous layer. Alternatively, the desired structure of the conductor can be generated by forming the conductor in the desired configuration to provide for electric contact to the connector 1 as well as an attachment point for an external supply lead in each embodiment.

Step 5 shows the result of the deposition of the radiation emitting layer 20 centrally across the entire surface of the device. Provision of a surface of the connector 1 accessible by the second electrode, e.g. during deposition of second electrode layer material, within the deposited radiation emitting layer 20 can be achieved preferably by removal of the radiation emitting layer subsequent to its deposition, especially preferable by evaporation using heating by laser irradiation in a vacuum chamber. Alternatively, connector 1 can be shielded from the deposition of radiation emitting layer 20 by a mask during the deposition process. When using removal of light emitting layer 20 from the connector 1 subsequent to deposition of the radiation emitting layer 20, deposition of the radiation emitting layer 20 can be effected by vapour deposition processes, doctor blading or spin coating from solution.

As shown in step 6, laser irradiation (indicated by arrows) or deposition using a mask (m) during deposition of the radiation emitting layer 20 results in a surface of the connector 1 accessible for contacting by a subsequently deposited second electrode 6, as shown in step 7. Deposition of the second electrode 6 material preferably is by sputtering.

When providing current to first electrode 2 and second electrode 6 by contacting e.g. the conductor 5, respectively with opposing polarity, a current is established between the parallel sections of first electrode 2 and second electrode 6, resulting in the generation of radiation in sections were radiation emitting layer 20 is contacted by both the first electrode 2 and second electrode 6.

For deposition of layers, e.g. in step 5 and/or step 6, e.g. for first electrode 2, emitting layer 20, second electrode 6, and insulating layers or sections, printing, e.g. serigraphy, ink jet printing, doctor blading, spin coating from a solution of the constituent compounds of the respective layers, or from a gas phase, e.g. by thermal or chemical vapour deposition or by sputtering of the constituent compounds or precursor compounds thereof.

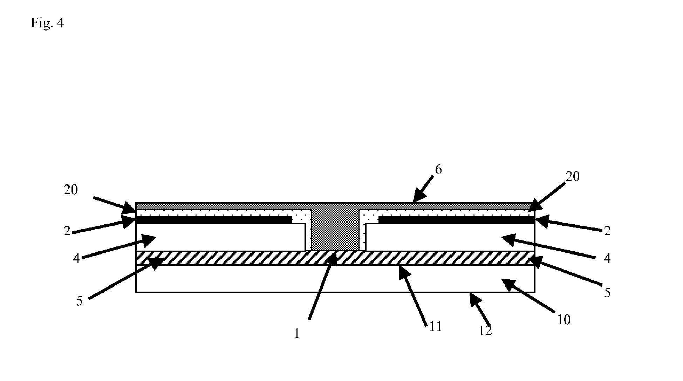

Figure 4 shows an embodiment of connectors 1 provided as sections of the conductor 5 which sections are accessible to and contacted by the second electrode 6. Apart from the specific structure of the connector 1, this embodiment can realize all the details as previously described herein, and vice versa. A specific advantage of this embodiment is that it can be manufactured by depositing the conductor 5 adjacent the first side 11 of substrate 10, an insulating material 13 to cover the conductor 5, wherein the conductor 5 and/or the insulating material preferably is a continuous layer, and then the first electrode 2. The insulating material 14 separates the conductor 5 from the first electrode 2 and provides the spacing 3 between the first electrode 2 and the conductor 5, and hence a spacing 3 between the first electrode 2 and the connector 1. Removing the first electrode 2 and the insulating material 14 from the conductor 5 provides the connector 1. Depositing of the radiation emitting layer 20, e.g. by coating from vapour or solution can be performed to cover the first electrode 2 including the connector 1, followed by removal of the radiation emitting layer at least from a portion of the connector 1, or depositing can exclude at least a portion of the connector 1, e.g. by masking of the portion of the connector 1.

Depositing of at least a fraction or portion of radiation emitting layer 20 to extend into spacing 3 covers first electrode 2 and accordingly provides for separation of the first electrode 2 from the second electrode 6. Second electrode 6 is subsequently deposited to cover radiation emitting layer 20 including connector 1 as well as regions between these, e.g. including the spacing 3 and its portions covered by radiation emitting layer 20 components or insulating material.

In general, the separation of first electrode from connector 1 by spacing 3 and the arrangement of at least a fraction of radiation emitting layer components and/or insulating material to cover the fraction of first electrode 2 adjacent spacing 3 provides for a sufficiently effective electric separation of the first electrode 2 from the second electrode 6 and the connector 1 connected thereto, resulting in an effective contacting of the superficial second electrode by connectors 1 which can be distributed across the area within the outer circumference of the radiation emitting layer 20, thus providing for an equal radiation intensity over the radiating area while avoiding additional leads within or on top of the second electrode. As a further advantage, contact points to the first and second electrodes are provided at the first surface side of the radiation emitting layer, e.g. adjacent the substrate 10, but not necessarily directly at the second electrode layer.

The structure of the radiation emitting device, which preferably is an OLED emitting visible light, can be produced by a simplified process because the connector 1 can be provided for access by and contact to the second electrode by removing the radiation emitting layer after its deposition from the area forming the connector 1, preferably by laser desorption, or by controlling the deposition process by standard measures to avoid coverage of the connector 1, e.g. by masking.

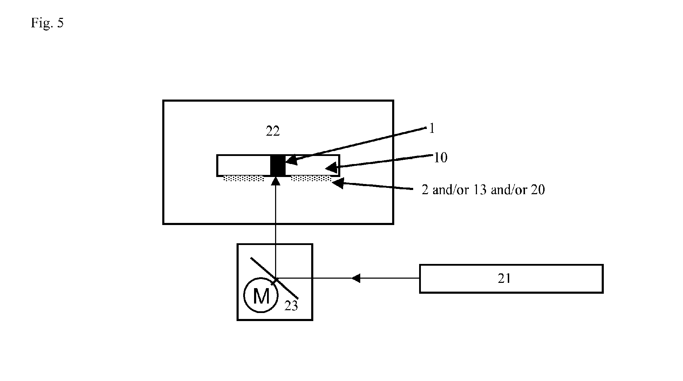

Figure 5 shows a device for removal of first electrode material 2 and compounds deposited thereon, e.g. radiation emitting or radiation collecting compounds 20. The device can be comprised in a production line and has a laser 21, the irradiation beam of which is directed to the substrate 10 arranged in an ultra-high vacuum chamber 22. For computer-controlled direction of the laser beam over the first surface of substrate 10 and optionally over the surface of connector 1, a computer-controlled mirror is preferably arranged in the path of the laser beam as an irradiation guidance 23. Irradiation of the substrate 10 and connector 1 by the laser beam generated by laser 21, e.g. with direction of the laser beam by irradiation guidance 23, results removal of first electrode 2, generating spacing 3 for providing insulation between connector 1 and first electrode 2. As schematically shown, the laser beam exiting laser 21 can pass the wall of vacuum chamber 22, which e.g. has a section of the wall of an irradiation transparent material. In the alternative to laser 21 being arranged outside vacuum chamber 22, laser 21, optionally including irradiation guidance 23 can be arranged within vacuum chamber 22 to avoid a wall section of vacuum chamber 22 interfering with the laser beam.

### Listing of reference numerals

- 1: connector
- 2: first electrode
- 3: spacing
- 5: conductor
- 6: second electrode
- 10: substrate
- 11: first side of substrate
- 12: second side of substrate
- 13: insulating material
- 14: insulating material
- 20: radiation emitting layer or radiation collecting layer
- 20a: first side of radiation emitting layer or of radiation collecting layer
- 20b: second side of radiation emitting layer or of radiation collecting layer
- 21: laser source
- 22: vacuum chamber
- 23: irradiation guidance

## Claims

1. Electro-optical device comprising a layer (20) having a first surface (20a) and an opposite second surface (20b), the layer (20) comprising a radiation emitting compound or a radiation collecting compound, the layer (20) being arranged between a first electrode (2) which with its first side (11) is in contact with the first side (20a) of layer (20), which first electrode (2) is supported by a substrate (10), and a second electrode (6) which is in contact with the second surface (20b) of layer (20), wherein at least one of the first electrode (2) and the second electrode (6) is at least partially radiation transparent, **characterized in that**
at least one electrically conductive connector (1) is arranged at the substrate (10), which connector (1) is electrically separated from the first electrode (2) by a spacing (3), and the second electrode (6) is in electric contact with the connector (1).

2. Device according to claim 1, **characterized in that** an insulating material extends into spacing (3), which insulating material is selected from a dielectric compound, at least a fraction of the compounds of the radiation emitting layer (20), and at least a fraction of the compounds of the radiation emitting layer arranged forming a non-conductive deposition between the first electrode (2) and the second electrode (6).

3. Device according to one of claims 1 or 2, **characterized in that** the first electrode (2) is arranged adjacent a first side (11) of a substrate (10) and the connector (1) is arranged in a recess of the substrate (10).

4. Device according to one of the preceding claims, **characterized in that** the radiation emitting layer (20) comprises an organic triplett or singlett emitter compound and/or organic charge transporting compounds.

5. Device according to one of the preceding claims, **characterized in that** the connector (1) is arranged in an opening connecting a first side (11) and an opposite second side (12) of the substrate (10), which connector (1) is contacted by a conductor (5) on the second side (12) of the substrate (10).

6. Device according to one of the preceding claims, **characterized in that** the connector (1) is formed by a portion of a conductor (5) which is arranged between the first electrode (2) and the substrate (10) with an insulating material (14) disposed between the conductor (5) and second electrode (2), wherein the portion of the conductor (5) forming the connector (1) is formed by a recess in the first electrode (2) and in the insulating material (14).

7. Device according to one of claims 2 to 6, **characterized in that** the conductor (5) forms a layer.

8. Device according to one of the preceding claims, **characterized in that** an insulating material (13) is arranged on the first side (11) of the substrate (10) at least partially covering spacing (3) and at least partially circumferentially to the connector (1).

9. Device according to one of the preceding claims, **characterized in that** the conductor (5) is arranged between the substrate (10) and the first electrode (2) with an insulating material disposed between the conductor (5) and the first electrode (2).

10. Light emitting device, **characterized by** comprising at least one device according to one of the preceding claims, arranged at least partially overlapping each other and/or arranged on a common support (10) neighbouring each other without overlap, wherein the first electrodes (2) are connected to the same lead connected to a first polarity of a power source, and wherein the second electrodes (6) are connected to leads connectable to a second polarity of a power source at different powers each.

11. Process for use in the production of a device according to one of the preceding claims, comprising the steps of
depositing a layer (20) with its first surface (2a) on a first electrode (2) supported a substrate (10), the layer (20) comprising a radiation emitting compound or a radiation collecting compound,
depositing a second electrode (6) on the second surface (20b) of layer (20) opposite its first surface (20b), wherein at least one of the first electrode (2) and the second electrode (6) is at least partially transparent to the radiation,
**characterized by**
arranging at the first side (11) of the substrate (10) at least one electrically conductive connector (1) separated from the first electrode (2) by a spacing (3),
providing of at least a portion of the connector (1) without layer (20), and
depositing the second electrode (6) contacting the connector (1).

12. Process according to claim 11, **characterized in that** the spacing (3) is generated by masking an area circumferential to the connector during the deposition of first electrode material, or by removal of first electrode material from an area circumferential to the connector (1) using laser irradiation.

13. Process according to claim 11, **characterized in that** providing of at least a portion of the connector (1) without radiation emitting layer (20) is by masking at least a portion of the connector (1) during depositing of the radiation emitting layer (20).

14. Process according to claim 11, **characterized in that** providing of at least a portion of the connector (1) without layer (20) is by removing layer (20) from at least a portion of the connector (1).

15. Process according to one of claims 11 to 14, **characterized by** arranging the connector (1) in an opening connecting the first side (11) and the second side (12) of the substrate (10), and contacting the connector (1) by a conductor (5) on the second side (12) of the substrate (10).

16. Process according to one of claims 11 to 15, **characterized by** forming the connector (1) by arranging a conductor (5) between the first electrode (2) and the substrate (10) with arranging an insulating material (14) between the conductor (5) and second electrode (2), and generating a recess in the first electrode (2) and in the insulating material (14) from a portion of the conductor (5).

17. Process according to one of claims 11 to 16, **characterized in that** depositing layer (20) and depositing of the second electrode (6) is independently by coating from solution and/or by vapour deposition and/or by sputtering.

18. Device for use in a process according to one of claims 11 to 17, comprising a vacuum chamber (22) for receiving substrate (10) comprising a connector (1) and having arranged on its first side (11) a first electrode layer (2) contacting connector (1), **characterized by** a laser (21) arranged to irradiate a section of substrate (10) circumferential to connector (1).
